# EUROPEAN PATENT SPECIFICATION

(11) **EP 3 614 421 B1**
(45) Date of publication and mention of the grant of the patent: **17.02.2021**
(21) Application number: 18784883.3
(22) Date of filing: 13.04.2018
(51) Int. Cl.: H01L 21/66, H01L 31/18, H01L 21/67

(54) **DEVICE AND METHOD FOR DETECTING BENDING AND WARPING OF SILICON WAFER OF SOLAR CELL**
VORRICHTUNG UND VERFAHREN ZUR ERKENNUNG VON BIEGEN UND VERZIEHEN EINES SILICIUMWAFERS EINER SOLARZELLE
DISPOSITIF ET PROCÉDÉ DE DÉTECTION DE COURBURE ET DE GAUCHISSEMENT D'UNE TRANCHE DE SILICIUM DE CELLULES SOLAIRES

(30) Priority: 14.04.2017 CN 201710243783
(43) Date of publication of application: 26.02.2020
(73) Proprietor: Eging Photovoltaic Technology Co., Ltd, Changzhou, Jiangsu 213213 (CN)
(72) Inventor: SUN, Tietun, Changzhou Jiangsu 213213 (CN); YAO, Weizhong, Changzhou Jiangsu 213213 (CN); TANG, Ping, Changzhou Jiangsu 213213 (CN)
(74) Representative: Algemeen Octrooi- en Merkenbureau B.V.
(86) International application number: PCT/CN2018/083021
(87) International publication number: WO 2018/188654

(56) References cited:
- CN-A- 105 789 082
- CN-A- 106 876 298
- CN-U- 201 844 980
- CN-U- 205 385 011
- CN-U- 206 628 448
- JP-A- S63 266 848
- JP-A- S63 266 848

## Description

### TECHNICAL FIELD

The present invention belongs to the technical field of solar cells, and in particular relates to a device and a method for detecting a bending degree and a warping degree of a silicon wafer of a solar cell after polishing.

### BACKGROUND

The main raw material for solar cells is silicon wafers. Silicon wafer as a semiconductor device, has surface lattice of abrupt termination characteristics, and has an unsaturated dangling bond for each silicon atom in the outermost layer of the surface. The corresponding electronic energy state is called surface state, in which the silicon wafer is extremely sensitive to the outside atmosphere, can have a surface recombination with photo-generated carriers. It may reduce the collection rate of minority carriers by p-n junctions, and thus seriously affect the stability, current, voltage and efficiency of solar cells

Therefore, when manufacturing a solar cell, it is necessary to perform back passivation treatment on the raw material of silicon wafer, to reduce the density of interface states by saturating dangling bonds on the surface of the silicon wafers. At the same time, the passivation film can also avoid introduction of impurities in the surface layer, reduce surface activity to reduce the surface recombination rate of minority carriers, and improve the service life of the cell. In addition, the passivation film forms a surface junction on the surface of the silicon wafer, which can reduce the loss of surface recombination, improve the collection rate of surface photo-generated carriers and improve a long wave effect of the cell.

The silicon wafer needs to be cleaned and polished before the back passivation treatment. Since the polished silicon wafer has a certain degree of bending and warping before polishing, if the bending degree and warping degree exceeds a specified range, the silicon wafer needs to be flipped over during the subsequent process. Since the surface is not flat, when a suction mechanism such as a suction cup is used to grasp the silicon wafer, it is easy to throw out the silicon wafer and break the silicon wafer, producing a large amount of silicon wafer fragments. It may on the one hand cause serious waste of raw materials, on the other hand, affect production efficiency CN 105789082 A and JP S63266848 A disclose devices known from the prior art.

### SUMMARY

The technical problem to be solved by the present invention is that in order to overcome the deficiencies in the prior art, the present invention provides a device and a method for detecting a bending degree and a warping degree of a silicon wafer of a solar cell.

The technical solution provided by the present invention to solve its technical problems is as follows. A device for detecting a bending degree and warping degree of a silicon wafer of a solar cell includes a detecting mechanism configured to detect the bending degree and warping degree of the silicon wafer of the solar cell; an uploading mechanism configured to grasp the silicon wafer of the solar cell on a conveying mechanism and place it on the detecting mechanism; and a downloading mechanism configured to remove the detected silicon wafer of the solar cell from the detecting mechanism. The detecting mechanism includes a bracket, and the conveying mechanism, a lifting mechanism and a detection box disposed on the bracket. The conveying mechanism is configured to support the silicon wafer of the solar cell to be detected being forwarded from the side of the uploading mechanism through the detection box to the side of the downloading mechanism. The lifting mechanism includes a lower carrier plate and a lifting cylinder disposed at the bottom of the lower carrier plate. The lifting cylinder drives the lower carrier plate to move up and down. The conveying mechanism above the lower carrier plate is provided with a photoelectric sensor. The photoelectric sensor is configured to detect whether the silicon wafer of the solar cell has moved on the lower carrier plate. The detection box is located directly above the lower carrier plate, and the detection box is a cylindrical empty box with an opening at a lower end. The lower carrier plate is sized to cover at least the opening at the lower end of the detection box. The detection box is internally provided with an image scanning assembly parallel to the lower carrier plate. The image scanning assembly includes an upper cover, a scanning lamp, a reflector, a mirror, a CCD camera, an image processing system, a computer and a display. The computer is installed with image processing software cooperated with the image processing system. The scanning lamp is located within an imaging chamber formed by the upper cover and the detection box, and located above the upper cover. The scanning lamp, the reflector, the mirror and the CCD camera are optically connected. The CCD camera is wired to the image processing system, the computer and the display. The image scanning assembly is configured to scan and image the silicon wafer of the solar cell. The upper cover is made of a transparent glass material and configured to transmit the light of the scanning lamp to image the silicon wafer of the solar cell being scanned.

Further, the uploading mechanism and the downloading mechanism both employ a three-legged suction cup.

Further, in order to ensure the smoothness of the operation and avoid jamming, the axial section of the lower carrier plate is an isosceles trapezoid having a large upper side and a small lower side. The inner wall at the opening of the detection box is in the same isosceles trapezoid as the lower carrier plate. The isosceles trapezoid can facilitate the lower carrier plate in and out of the detection box.

Further, in order to ensure stability and reduce noise during the operation of the components, the contact surface of the lower end opening of the detection box and the lower carrier plate is provided with a sealing buffer layer in the circumferential direction. The height H1 of the sealing buffer layer is greater than the thickness H2 of the silicon wafer of the solar cell. The sealing buffer layer has a sealing function to prevent external light from entering, to avoid affecting the image imaging effect and avoid blurring of the image edge, and improve the detection accuracy. In addition, when the lower carrier plate is raised, the lower carrier plate may collide with the inner wall of the lower end opening of the detection box, which may easily cause damage to the optical components inside the detection box or lower the optical path transmission accuracy. Therefore, the sealing buffer layer can effectively reduce the impact of the lower carrier plate and the detection box on the optical system, and further ensure the accuracy of the detection. In order to prevent the lower carrier plate and the upper cover from crushing the silicon wafer of the solar cell, it is necessary to ensure that the distance between the two is greater than the thickness H1 of the silicon wafer of the solar cell. So the sealing buffer layer also functions as a positioning limit.

A method for detecting a bending degree and warping degree of the silicon wafer of the solar cell, the method using the above-mentioned device for detecting a bending degree and warping degree of a silicon wafer of a solar cell, and including the following steps.

The uploading mechanism places the silicon wafer of the solar cell on the conveying mechanism, and the conveying mechanism drives the silicon wafer of the solar cell to move toward the detection box. When the photoelectric sensor detects that the silicon wafer of the solar cell arrives on the lower carrier plate, the lifting cylinder drives the lower carrier plate to move from bottom to top, so that the lower carrier plate is covered on the lower end opening of the detection box, there is no light inside of the detection box. Then, the scanning lamp is activated to make the scanning lamp to move from one side of the detection box to the other side. The light of the scanning lamp is irradiated onto the silicon wafer of the solar cell, and is sequentially reflected by the silicon wafer of the solar cell, the reflector and the mirror into the CCD camera for imaging. The image formed by the CCD camera is transmitted to the image processing system. The image processing system processes the image of the silicon wafer of the solar cell and compares it with a standard image, and sends the comparison result to the computer to be displayed by the display. At the same time, the image processing software installed on the computer and cooperated with the image processing system performs parameter adjustment, and data analysis and comparison.

The invention has the beneficial effects that the invention discloses a device and a method for detecting a bending degree and warping degree of a silicon wafer of a solar cell after polishing, adopts the principle of imaging to scan and image a silicon wafer of a solar cell, and compares the imaging result with a standard image, to determine whether the silicon wafer of the solar cell meets the requirements of bending degree and warping degree; and the detection is convenient and quick.

### BRIEF DESCRIPTION OF THE DRAWINGS

The invention will now be further described with reference to the accompanying drawings and embodiments.
Fig. 1 is a schematic diagram showing a structure of a preferred embodiment of the present invention;
Fig. 2 is a schematic diagram of a detection state; and
Fig. 3 is a schematic diagram of a detection principle.

In the drawings: 1, silicon wafer of solar cell, 2, conveying mechanism, 3, lifting cylinder, 4, lower carrier plate, 5, detection box, 6, upper cover, 7, image processing system, 8, computer, 9, scanning lamp, 10, sealing buffer layer, 11, standard silicon wafer, 12, warped silicon wafer.

### DETAILED DESCRIPTION

The invention will now be described in detail in conjunction with the drawings. This drawing is a simplified schematic diagram illustrating the basic structure of the present invention only in a schematic manner, and thus it shows only the configuration related to the present invention.

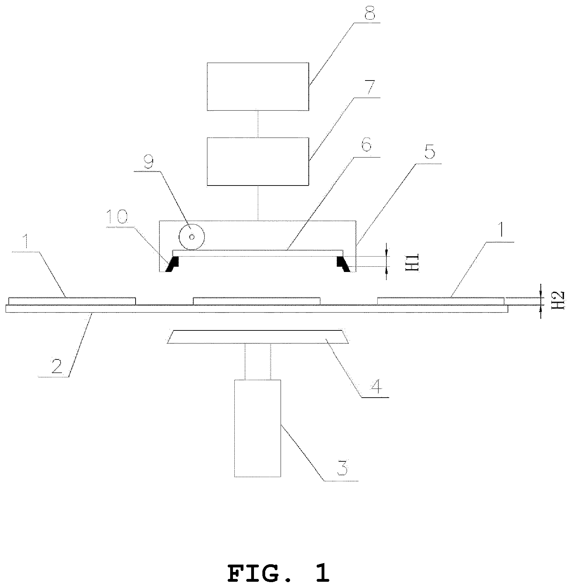

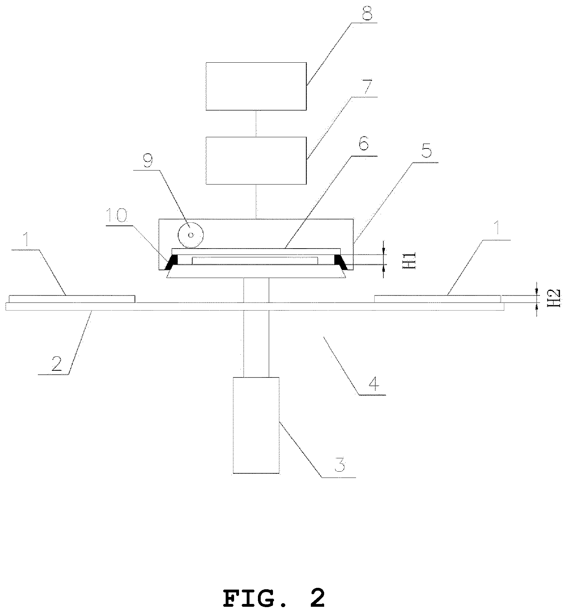

As shown in FIGS. 1-2, a device for detecting a bending degree and warping degree of a silicon wafer 1 of a solar cell includes a detecting mechanism configured to detect the bending degree and warping degree of the silicon wafer 1 of the solar cell; an uploading mechanism configured to grasp the silicon wafer 1 of the solar cell on a conveying mechanism 2 and place it on the detecting mechanism; and a downloading mechanism configured to remove the detected silicon wafer 1 of the solar cell from the detecting mechanism. The detecting mechanism includes a bracket, and the conveying mechanism 2, a lifting mechanism and a detection box 5 disposed on the bracket. The conveying mechanism 2 is configured to support the silicon wafer 1 of the solar cell to be detected being forwarded from the side of the uploading mechanism through the detection box 5 to the side of the downloading mechanism. The lifting mechanism includes a lower carrier plate 4 and a lifting cylinder 3 disposed at the bottom of the lower carrier plate 4. The lifting cylinder 3 drives the lower carrier plate 4 to move up and down. The conveying mechanism 2 above the lower carrier plate 4 is provided with a photoelectric sensor. The photoelectric sensor is configured to detect whether the silicon wafer 1 of the solar cell has moved on the lower carrier plate 4. The detection box 5 is located directly above the lower carrier plate 4, and the detection box 5 is a cylindrical empty box with an opening at a lower end. The lower carrier plate 4 is sized to cover at least the opening at the lower end of the detection box 5. The detection box 5 is internally provided with an image scanning assembly parallel to the lower carrier plate 4. The image scanning assembly includes an upper cover 6, a scanning lamp 9, a reflector, a mirror, a CCD camera, an image processing system 7, a computer 8 and a display. The computer 8 is installed with image processing software cooperated with the image processing system 7. The scanning lamp 9 is located within an imaging chamber formed by the upper cover 6 and the detection box 5, and located above the upper cover 6. The scanning lamp 9, the reflector, the mirror and the CCD camera are optically connected. The CCD camera is wired to the image processing system 7, the computer 8 and the display. The image scanning assembly is configured to scan and image the silicon wafer 1 of the solar cell. The upper cover 6 is made of a transparent glass material and configured to transmit the light of the scanning lamp 9 to image the silicon wafer 1 of the solar cell being scanned.

Further, the uploading mechanism and the downloading mechanism both employ a three-legged suction cup.

Further, in order to ensure the smoothness of the operation and avoid jamming, the axial section of the lower carrier plate 4 is an isosceles trapezoid having a large upper side and a small lower side. The inner wall at the opening of the detection box 5 is in the same isosceles trapezoid as the lower carrier plate 4. The isosceles trapezoid can facilitate the lower carrier plate 4 in and out of the detection box 5.

Further, in order to ensure stability and reduce noise during the operation of the components, the contact surface of the lower end opening of the detection box 5 and the lower carrier plate 4 is provided with a sealing buffer layer 10 in the circumferential direction. The height H1 of the sealing buffer layer 10 is greater than the thickness H2 of the silicon wafer 1 of the solar cell. The sealing buffer layer 10 has a sealing function to prevent external light from entering, to avoid affecting the image imaging effect and avoid blurring of the image edge, and improve the detection accuracy. In addition, when the lower carrier plate 4 is raised, the lower carrier plate 4 may collide with the inner wall of the lower end opening of the detection box 5, which may easily cause damage to the optical components inside the detection box 5 or lower the optical path transmission accuracy. Therefore, the sealing buffer layer 10 can effectively reduce the impact of the lower carrier plate 4 and the detection box 5 on the optical system, and further ensure the accuracy of the detection. In order to prevent the lower carrier plate 4 and the upper cover 6 from crushing the silicon wafer 1 of the solar cell, it is necessary to ensure that the distance between the two is greater than the thickness H1 of the silicon wafer 1 of the solar cell. So the sealing buffer layer 10 also functions as a positioning limit.

A method for detecting a bending degree and warping degree of the silicon wafer 1 of the solar cell, the method using the above-mentioned device for detecting a bending degree and warping degree of a silicon wafer 1 of a solar cell, and including the following steps.

The uploading mechanism places the silicon wafer 1 of the solar cell on the conveying mechanism 2, and the conveying mechanism 2 drives the silicon wafer 1 of the solar cell to move toward the detection box 5. When the photoelectric sensor detects that the silicon wafer 1 of the solar cell arrives on the lower carrier plate 4, the lifting cylinder 3 drives the lower carrier plate 4 to move from bottom to top, so that the lower carrier plate 4 is covered on the lower end opening of the detection box 5, there is no light inside of the detection box 5. Then, the scanning lamp 9 is activated to make the scanning lamp 9 to move from one side of the detection box 5 to the other side. The light of the scanning lamp 9 is irradiated onto the silicon wafer 1 of the solar cell, and is sequentially reflected by the silicon wafer 1 of the solar cell, the reflector and the mirror into the CCD camera for imaging. The image formed by the CCD camera is transmitted to the image processing system 7. The image processing system 7 processes the image of the silicon wafer 1 of the solar cell and compares it with a standard image, and sends the comparison result to the computer 8 to be displayed by the display. At the same time, the image processing software installed on the computer 8 and cooperated with the image processing system 7 performs parameter adjustment, and data analysis and comparison.

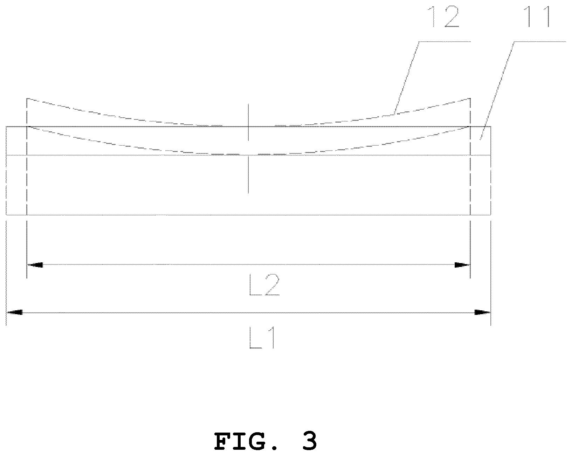

As shown in FIG. 3, when the silicon wafer 1 of the solar cell is bent and warped, the outer size L2 of the warped silicon wafer 12 is surely smaller than the outer size L1 of the standard silicon wafer 11, and the deformation rate can be calculated. If it is within an allowable range, no processing is required, and if it is greater than a provided requirement, the warped silicon wafer 12 needs to be corrected or discarded.

In view of the above-described embodiments of the present invention, from the above description, various changes and modifications can be made by those skilled in the art without departing from the scope of the invention. The technical scope of the present invention is not limited to the contents of the specification, and the technical scope thereof should be determined according to the scope of the claims.

## Claims

1. A device for detecting a bending degree and warping degree of a silicon wafer (1) of a solar cell, wherein the device comprises
- a detecting mechanism configured to detect the bending degree and warping degree of the silicon wafer (1) of the solar cell;
- an uploading mechanism configured to grasp the silicon wafer (1) of the solar cell and to place the silicon wafer (1) of the solar cell on the detecting mechanism; and
- a downloading mechanism configured to remove the detected silicon wafer of the solar cell from the detecting mechanism; and
- a conveying mechanism (2);
wherein the detecting mechanism comprises a bracket and a detection box (5) disposed on the bracket, and the conveying mechanism comprises a lifting mechanism (3;4), wherein the conveying mechanism is configured to support the silicon wafer (1) of the solar cell to be detected being forwarded from a side of the uploading mechanism through the detection box (5) to a side of the downloading mechanism, wherein the lifting mechanism (3;4) comprises a lower carrier plate (4) and a lifting cylinder (3) disposed at the bottom of the lower carrier plate (4), wherein the lifting cylinder is configured to drive the lower carrier plate to move up and down, and wherein the conveying mechanism above the lower carrier plate (4) is provided with a photoelectric sensor and with the detection box (5) being located directly above the lower carrier plate (4), wherein the detection box (5) is configured as a cylindrical empty box with an opening at a lower end, and wherein the lower carrier plate (4) is sized to cover at least the opening at the lower end of the detection box (5), the detection box being internally provided with an image scanning assembly parallel to the lower carrier plate (4), the image scanning assembly comprises an upper cover (6), a scanning lamp (9), a reflector, a mirror, a CCD camera, an image processing system (7), a computer (8) and a display, wherein the computer (8) is installed with image processing software configured to cooperate with the image processing system (7), wherein the scanning lamp (9) is located within an imaging chamber formed by the upper cover and the detection box (5), and is located above the upper cover, the scanning lamp (9), the reflector, the mirror and the CCD camera are optically connected, and the CCD camera is wired to the image processing system (7), the computer (8) and the display.

2. The device for detecting a bending degree and warping degree of a silicon wafer of a solar cell according to claim 1, wherein the uploading mechanism and the downloading mechanism both employ a three-legged suction cup.

3. The device for detecting a bending degree and warping degree of a silicon wafer of a solar cell according to claim 1, wherein an axial section of the lower carrier plate (4) is configured as an isosceles trapezoid having a large upper side and a small lower side, and an inner wall at the opening of the detection box (5) is in the same isosceles trapezoid as the lower carrier plate (4).

4. The device for detecting a bending degree and warping degree of a silicon wafer of a solar cell according to any one of claims 1-3, wherein a contact surface of the lower end opening of the detection box (5) and the lower carrier plate (4) is provided with a sealing buffer layer (10) in a circumferential direction, and a height H1 of the sealing buffer layer (10) is greater than a thickness H2 of the silicon wafer (1) of the solar cell.

5. A method for detecting a bending degree and warping degree of a silicon wafer of a solar cell, with the use of the device for detecting a bending degree and warping degree of a silicon wafer of a solar cell according to any one of claims 1-4, wherein the method comprises the steps of:
a) placing, with the use of the uploading mechanism, the silicon wafer of the solar cell on the conveying mechanism, and
b) driving, with the use of the conveying mechanism, the silicon wafer of the solar cell towards the detection box,
c) detecting, with the use of the photoelectric sensor. whether the silicon wafer of the solar cell has arrived on the lower carrier plate,
d) driving, with the use of the lifting cylinder, the lower carrier plate to move from bottom to top, such that the lower carrier plate is covering the lower end opening of the detection box, and thus to prevent light from entering in the detection box;
e) activating the scanning lamp thereby moving the scanning lamp from one side of the detection box to the other side, and
f) irradiating the silicon wafer of the solar cell with light of the scanning lamp, and
g) sequentially reflecting light by the silicon wafer of the solar cell, the reflector and the mirror into the CCD camera for imaging,
h) transmitting the image being formed by the CCD camera to the image processing system,
i) processing, with the use of the image processing system, the image of the silicon wafer of the solar cell and
j) comparing the processed image of the silicon wafer of the solar cell with a standard image, and
k) sending the comparison result to the computer to be displayed by the display, and
l) at the same time, performing, with the use of the image processing software installed on the computer and cooperating with the image processing system, parameter adjustment, and data analysis and comparison.

## Patentansprüche

1. Vorrichtung zum Detektieren eines Verbiegungsgrads und eines Verzugsgrads eines Siliziumwafers (1) einer Solarzelle, wobei die Vorrichtung Folgendes umfasst
- einen Detektionsmechanismus, der dazu ausgelegt ist, den Verbiegungsgrad und den Verzugsgrad des Siliziumwafers (1) der Solarzelle zu detektieren;
- einen Auflademechanismus, der dazu ausgelegt ist, den Siliziumwafer (1) der Solarzelle zugreifen und den Siliziumwafer (1) der Solarzelle auf dem Detektionsmechanismus zu platzieren; und
- einen Ablademechanismus, der dazu ausgelegt ist, den detektierten Siliziumwafer der Solarzelle vom Detektionsmechanismus zu entfernen; und
- einen Fördermechanismus (2);
wobei der Detektionsmechanismus eine Halterung und einen Detektionskasten (5), der an der Halterung angeordnet ist, umfasst und der Fördermechanismus einen Hebemechanismus (3;4) umfasst, wobei der Fördermechanismus dazu ausgelegt ist, den Siliziumwafer (1) der Solarzelle derart zu stützen, dass er detektiert wird, wenn er von einer Seite des Auflademechanismus durch den Detektionskasten (5) zu einer Seite des Ablademechanismus geleitet wird, wobei der Hebemechanismus (3;4) eine untere Trägerplatte (4) und einen Hebezylinder (3), der am Boden der Trägerplatte (4) angeordnet ist, umfasst, wobei der Hebezylinder dazu ausgelegt ist, die untere Trägerplatte derart anzutreiben, dass sie sich nach oben und nach unten bewegt, und wobei der Fördermechanismus über der unteren Trägerplatte (4) mit einem photoelektrischen Sensor versehen ist und wobei sich der Detektionskasten (5) direkt über der unteren Trägerplatte (4) befindet, wobei der Detektionskasten (5) als ein zylindrischer leerer Kasten mit einer Öffnung am unteren Ende ausgelegt ist und wobei die untere Trägerplatte (4) derart bemessen ist, dass sie mindestens die Öffnung am unteren Ende des Detektionskastens (5) abdeckt, wobei der Detektionskasten intern mit einer Bildscananordnung versehen ist, die parallel zur unteren Trägerplatte (4) verläuft, wobei die Bildscananordnung eine obere Abdeckung (6), eine Scanleuchte (9), einen Reflektor, einen Spiegel, eine CCD-Kamera, ein Bildverarbeitungssystem (7), einen Computer (8) und eine Anzeige umfasst, wobei auf dem Computer (8) eine Bildverarbeitungssoftware installiert ist, die dazu ausgelegt ist, mit dem Bildverarbeitungssystem (7) zusammenzuwirken, wobei sich die Scanleuchte (9) in einer Bildgebungskammer befindet, die von der oberen Abdeckung und vom Detektionskasten (5) gebildet wird und sich über der oberen Abdeckung befindet, die Scanleuchte (9), der Reflektor, der Spiegel und die CCD-Kamera optisch verbunden sind und die CCD-Kamera mit dem Bildverarbeitungssystem (7), dem Computer (8) und der Anzeige verdrahtet ist.

2. Vorrichtung zum Detektieren eines Verbiegungsgrads und eines Verzugsgrads eines Siliziumwafers einer Solarzelle nach Anspruch 1, wobei der Auflademechanismus und der Ablademechanismus beide einen Saugnapf mit drei Beinen einsetzen.

3. Vorrichtung zum Detektieren eines Verbiegungsgrads und eines Verzugsgrads eines Siliziumwafers einer Solarzelle nach Anspruch 1, wobei ein axialer Bereich der unteren Trägerplatte (4) als ein gleichschenkliges Trapez mit einer großen Oberseite und einer kleinen Unterseite ausgelegt ist und sich eine Innenwand an der Öffnung des Detektionskastens (5) im selben gleichschenkligen Trapez wie die untere Trägerplatte (4) befindet.

4. Vorrichtung zum Detektieren eines Verbiegungsgrads und eines Verzugsgrads eines Siliziumwafers einer Solarzelle nach einem der Ansprüche 1-3, wobei eine Kontaktfläche der Öffnung am unteren Ende des Detektionskastens (5) und an der unteren Trägerplatte (4) in einer Umfangsrichtung mit einer Dichtungspufferschicht (10) versehen ist und eine Höhe H1 der Dichtungspufferschicht (10) größer ist als eine Dicke H2 des Siliziumwafers (1) der Solarzelle.

5. Verfahren zum Detektieren eines Verbiegungsgrads und eines Verzugsgrads eines Siliziumwafers einer Solarzelle unter Verwendung der Vorrichtung zum Detektieren eines Verbiegungsgrads und eines Verzugsgrads eines Siliziumwafers einer Solarzelle nach einem der Ansprüche 1-4, wobei das Verfahren die folgenden Schritte umfasst:
a) Platzieren des Siliziumwafers der Solarzelle unter Verwendung des Auflademechanismus auf dem Fördermechanismus und
b) Antreiben des Siliziumwafers der Solarzelle unter Verwendung des Fördermechanismus zum Detektionskasten,
c) Detektieren unter Verwendung des photoelektrischen Sensors, ob der Siliziumwafer der Solarzelle auf der unteren Trägerplatte angekommen ist,
d) Antreiben der unteren Trägerplatte unter Verwendung des Hebezylinders derart, dass sie sich von unten nach oben bewegt, derart, dass die untere Trägerplatte die Öffnung am unteren Ende des Detektionskastens abdeckt und so verhindert, dass Licht in den Detektionskasten eindringt;
e) Aktivieren der Scanleuchte, dadurch Bewegen der Scanleuchte von einer Seite des Detektionskastens zur anderen Seite, und
f) Bestrahlen des Siliziumwafers der Solarzelle mit Licht der Scanleuchte und
g) sequenzielles Reflektieren von Licht durch den Siliziumwafer der Solarzelle, den Reflektor und den Spiegel zur Bildgebung in die CCD-Kamera,
h) Übertragen des Bildes, das von der CCD-Kamera gebildet wird, zum Bildverarbeitungssystem,
i) Verarbeiten des Bildes des Siliziumwafers der Solarzelle unter Verwendung des Bildverarbeitungssystems und
j) Vergleichen des verarbeiteten Bildes des Siliziumwafers der Solarzelle mit einem Standardbild und
k) Senden des Vergleichsergebnisses an den Computer zum Anzeigen durch die Anzeige und
l) gleichzeitiges Durchführen einer Parameteranpassung und einer Datenanalyse und eines Vergleichs unter Verwendung der Bildverarbeitungssoftware, die im Computer installiert ist und mit dem Bildverarbeitungssystem zusammenwirkt.

## Revendications

1. Dispositif de détection d'un degré de flexion et d'un degré de gauchissement d'une tranche de silicium (1) d'une cellule solaire, dans lequel le dispositif comprend
- un mécanisme de détection configuré pour détecter le degré de flexion et le degré de gauchissement de la tranche de silicium (1) de la cellule solaire ;
- un mécanisme de chargement configuré pour saisir la tranche de silicium (1) de la cellule solaire et pour placer la tranche de silicium (1) de la cellule solaire sur le mécanisme de détection ; et
- un mécanisme de déchargement configuré pour retirer la tranche de silicium détectée de la cellule solaire du mécanisme de détection ; et
- un mécanisme de transport (2) ;
dans lequel le mécanisme de détection comprend un support et une boîte de détection (5) disposée sur le support, et le mécanisme de transport comprend un mécanisme de levage (3 ; 4), où le mécanisme de transport est configuré pour supporter la tranche de silicium (1) de la cellule solaire à détecter étant acheminée d'un côté du mécanisme de chargement à travers la boîte de détection (5) à un côté du mécanisme de déchargement, où le mécanisme de levage (3 ; 4) comprend une plaque d'appui inférieure (4) et un vérin de levage (3) disposé au niveau de la partie inférieure de la plaque d'appui inférieure (4), où le vérin de levage est configuré pour entraîner la plaque d'appui inférieure pour se déplacer vers le haut et vers le bas, et où le mécanisme de transport au-dessus de la plaque d'appui inférieure (4) est pourvu d'un capteur photoélectrique et de la boîte de détection (5) qui est située directement au-dessus de la plaque d'appui inférieure (4), où la boîte de détection (5) est configurée sous forme de boîte vide cylindrique avec une ouverture au niveau d'une extrémité inférieure, et où la plaque d'appui inférieure (4) est dimensionnée de manière à couvrir au moins l'ouverture au niveau de l'extrémité inférieure de la boîte de détection (5), la boîte de détection étant pourvue intérieurement d'un ensemble de balayage d'image parallèle à la plaque d'appui inférieure (4), l'ensemble de balayage d'image comprend un couvercle supérieur (6), une lampe de balayage (9), un réflecteur, un miroir, une caméra à dispositif à transfert de charge (CCD), un système de traitement d'image (7), un ordinateur (8) et un dispositif d'affichage, où l'ordinateur (8) est installé avec un logiciel de traitement d'image configuré pour coopérer avec le système de traitement d'image (7), où la lampe de balayage (9) est située dans une chambre de formation d'image formée par le couvercle supérieur et la boîte de détection (5), et est située au-dessus du couvercle supérieur, la lampe de balayage (9), le réflecteur, le miroir et la caméra CCD sont connectés optiquement, et la caméra CCD est câblée au système de traitement d'image (7), à l'ordinateur (8) et au dispositif d'affichage.

2. Dispositif de détection d'un degré de flexion et d'un degré de gauchissement d'une tranche de silicium d'une cellule solaire selon la revendication 1, dans lequel le mécanisme de chargement et le mécanisme de déchargement utilisent tous deux une ventouse tripode.

3. Dispositif de détection d'un degré de flexion et d'un degré de gauchissement d'une tranche de silicium d'une cellule solaire selon la revendication 1, dans lequel une section axiale de la plaque d'appui inférieure (4) est configurée sous forme d'un trapèze isocèle ayant un grand côté supérieur et un petit côté inférieur, et une paroi interne au niveau de l'ouverture de la boîte de détection (5) est dans le même trapèze isocèle que la plaque d'appui inférieure (4).

4. Dispositif de détection d'un degré de flexion et d'un degré de gauchissement d'une tranche de silicium d'une cellule solaire selon l'une quelconque des revendications 1 à 3, dans lequel une surface de contact de l'ouverture d'extrémité inférieure de la boîte de détection (5) et de la plaque d'appui inférieure (4) est pourvue d'une couche tampon d'étanchéité (10) dans une direction circonférentielle, et une hauteur H1 de la couche tampon d'étanchéité (10) est supérieure à une épaisseur H2 de la tranche de silicium (1) de la cellule solaire.

5. Procédé de détection d'un degré de flexion et d'un degré de gauchissement d'une tranche de silicium d'une cellule solaire, en utilisant le dispositif de détection d'un degré de flexion et d'un degré de gauchissement d'une tranche de silicium d'une cellule solaire selon l'une quelconque des revendications 1 à 4, dans lequel le procédé comprend les étapes qui consistent :
a) à placer, en utilisant le mécanisme de chargement, la tranche de silicium de la cellule solaire sur le mécanisme de transport, et
b) à entraîner, en utilisant le mécanisme de transport, la tranche de silicium de la cellule solaire vers la boîte de détection,
c) à détecter, en utilisant le capteur photoélectrique, si la tranche de silicium de la cellule solaire est arrivée sur la plaque d'appui inférieure,
d) à entraîner, en utilisant le vérin de levage, la plaque d'appui inférieure pour se déplacer de bas en haut, de sorte que la plaque d'appui inférieure couvre l'ouverture d'extrémité inférieure de la boîte de détection, et pour ainsi empêcher la lumière d'entrer dans la boîte de détection ;
e) à activer la lampe de balayage, déplaçant ainsi la lampe de balayage d'un côté de la boîte de détection à l'autre côté, et
f) à irradier la tranche de silicium de la cellule solaire avec la lumière de la lampe de balayage, et
g) à réfléchir séquentiellement la lumière par la tranche de silicium de la cellule solaire, le réflecteur et le miroir dans la caméra CCD pour former une image,
h) à transmettre l'image qui est formée par la caméra CCD au système de traitement d'image,
i) à traiter, en utilisant le système de traitement d'image, l'image de la tranche de silicium de la cellule solaire et
j) à comparer l'image traitée de la tranche de silicium de la cellule solaire à une image standard, et
k) à envoyer le résultat de comparaison à l'ordinateur pour qu'il soit affiché par le dispositif d'affichage, et
l) en même temps, à réaliser, en utilisant le logiciel de traitement d'image installé sur l'ordinateur et coopérant avec le système de traitement d'image, le réglage de paramètres, l'analyse et la comparaison de données.
